# EUROPEAN PATENT SPECIFICATION

(11) **EP 1 645 920 B1**
(45) Date of publication and mention of the grant of the patent: **26.03.2008**
(21) Application number: 04023987.3
(22) Date of filing: 08.10.2004
(51) Int. Cl.: G05B 9/02, H05K 7/14, G05B 19/05

(54) **Modular safety system having hidden setting means**
Modulares Sicherheitssystem mit versteckten Einstellmitteln
Système modulaire de sécurité avec des moyens de réglage cachés

(43) Date of publication of application: 12.04.2006
(73) Proprietor: Rockwell Automation Germany GmbH & Co. KG, 42329 Wuppertal (DE)
(72) Inventor: Papenbreer, Rudolf L., 42115 Wuppertal (DE); Machuletz, Norbert, 58300 Wetter (DE); Lorenz, Dirk, 58089 Hagen (DE)
(74) Representative: Englaender, Klaus

(56) References cited:
- US-A- 4 558 914
- US-A1- 2003 058 623
- FREDERICKSON T ET AL: "COMPARISON OF FAULT TOLERANT CONTROLLERS USED IN SAFETY APPLICATIONS" ISA TRANSACTIONS, INSTRUMENT SOCIETY OF AMERICA. PITTSBURGH, US, vol. 30, no. 4, January 1991 (1991-01), pages 97-106, XP000275597 ISSN: 0019-0578

## Description

The invention relates to a modular safety system for safety control in emergency stop applications, in particular industrial emergency stop applications, according to the preamble of claim 1.

Modular safety systems for safety control in emergency stop applications are, for example, used for the control of robot cells, wherein the access to the robot cell and the operation of said robot must be controlled under various manufacturing conditions. Usually, the inputs to such a modular safety system include an emergency stop switch, a safety gate with an additional monitored door fastening device, safety mats, safety light curtains, and the robot position. Depending on the input conditions an output signal is created by the modular safety system to switch a safety relay for an emergency stop of the robot. Various other applications in industrial safety control exist.

For simple manufacturing tasks safety switching devices are very widely spread, however, in fully automated manufacturing plants they are limited for cost reasons or because they do not provide for diagnosis and monitoring in higher order controllers. On the other side, complex failure safe controllers are used in extremely sophisticated manufacturing facilities, however, they are too costly for small and midrange applications, further programming systems are required resulting in high engineering costs and the handling can only be done be specifically trained staff.

In mid-rage and even in small-range applications modular safety systems are used due to their cost-effectiveness.

One of those known modular safety systems is the F-200-system of Tesch GmbH & Co. KG, Wuppertal, a description of which can be found in the internet under the address **www.tesch.de**. This modular safety system comprises a base module, which has two input channels with a single-, dual or three-channel activation, independently of one another. Therefore, for example, an emergency stop switch and a safety gate with an additionally monitored door fastening device can be connected, so that each contact can be monitored independently. Also, foot switch mats or safety mats and safety light curtains with relay outputs can be used as initiating devices. The base module monitors the individual channels constantly to check the connection to one another and to check for interruptions. It opens the safety contacts if either an appropriate E-stop or fault condition occurs. The status of input/output and diagnostic information are indicated by LED lamps, signalled by relay contacts and semiconductor outputs, and are also transmitted to a serial data interface on the front of the module. That base module may be expanded by additional safety input extension modules and/or contact extension modules.

A further example of a known modular safety system is the safety center of Schleicher Elektronik GmbH & Co. KG, D-13597 Berlin, **www.Schleicher-de.com,** using a base module and at least one input module. The safety center has two multifunction groups A and B, which can operate as independent devices or be combined with one another. Separate or joint operation of the input circuit groups A and B on the input module is configured with a switch on the front of the base module. Input function selection is done by the use of two rotary switches located in the front plane of the input module.

Other similar modular safety systems can be found in documents US 2003/0058623 A1 and US 4, 558, 914 and in Frederickson, "Comparison of Fault Tolerant Controllers Used in Safety Applications", ISA Transactions, 1991.

Said known modular safety systems have the disadvantage, that the setting means for the required input and output functions are easy accessible even for unauthorized personnel.

It is therefore an object of the present invention to improve the safety features of a modular safety system for safety control in emergency stop applications.

This object is solved by a modular safety system with the features of claim 1. Preferred embodiments are subject of the dependent claims.

A modular safety system for safety control in emergency stop applications according to the invention comprises a base module and at least one extension module, wherein each module is arranged in a housing with a rail-mounting base so that the modules are located side by side to each other after mounting to said rail, and comprises further means for setting the required input and output functions, wherein said setting means is located on a side wall of said module housing, so that after mounting of said at least two modules to said rail the setting means is covered or hidden by a housing side wall of said adjacent module.

In a preferred embodiment said setting means is provided at a housing side wall of said at least one extension module. In particular, said extension module is realised by an input module with one or more input channels, in particular two input channels. Preferably, that input channels comprise a single ― dual ― or three ― channel activation.

Preferably, said setting means is realised by rotary switches and it is further preferred that system redundancy is provided by the use of two independent rotary switches for the input functions and two independent rotary switches for the output functions. Further, preferably the modular safety system according to the invention comprises at least one output module for the control of the safety contacts, in other words the control of the safety relays or safety contacts is dislocated from the base module to an output module, to further enhance the modularity of the modular safety system.

In a preferred embodiment the base module is comprised in a 35 mm-housing, the input module is comprised in a 17,5 mm-housing, and the output module is comprised in a 22,5 mm-housing.

A preferred embodiment of a modular safety system according to the invention is shown in the accompanying drawings, wherein
Fig. 1 shows a modular safety system with three modules, and
Fig. 2 shows the input module with the setting means located on one housing side in schematic view.

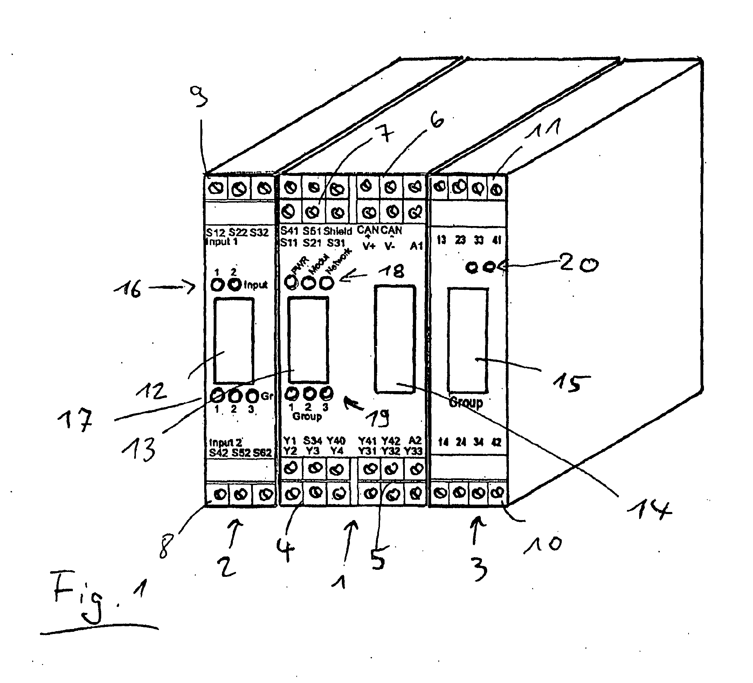

Fig. 1 shows a modular safety system according to the invention comprising a base module 1, an input module 2 and an output module 3. These modules 1, 2, 3 are arranged in a side by side fashion on a mounting rail (not shown). The base module 1 comprises two lower terminal rows 4, 5 and two upper terminal rows 6, 7 for attaching the necessary cable connections for input and output signals, power supply, reset configuration, outputs for safety loops, device net, etc.

Also the input module 2 as well as the output module 3 both comprise a lower terminal row 8, 10 and an upper terminal row 9, 11, each comprising various terminals.

In the input module 2, the upper terminal 9 serves as first input, whereas the lower terminal row serves as second input, with a maximum of three channel activations. The modules 1, 2, 3 are interconnected by two different types of flat cables (not shown) through their sockets 12, 13, 14, and 15. Socket 12 of the input module is interconnected with such a cable with socket 13 of the base module for delivering the input information for the base module, whereas socket 14 is connected to socket 15 of the output module to transport the output information to the output module 3. Further, a plurality of LEDs of each module serves for information about the state of the module, respectively.

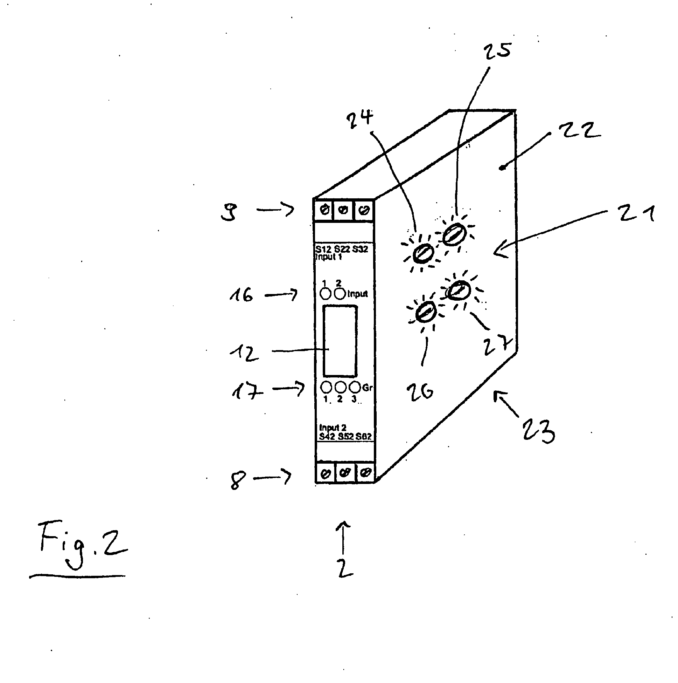

Because a plurality of input modules 2 may be connected to base module 1 as well as a plurality of output modules 3 may be connected base module 1, it is necessary to define input and output functions for the modular safety system. As it is shown in Fig. 2, depicting an input module 2 in schematic view, a setting means 21 is provided in the right side wall 22 of the housing 23 of the input module 2. In the preferred embodiment the setting means 21 comprises a first pair of rotary switches 24, 25 and a second pair of rotary switches 26 and 27. The first pair 24 und 25 is used for the definition of the input functions, whereas the second pair of rotary switches 26 and 27 is used for the definition of the output functions. Preferably, the rotary switches 24, 25, 26, 27 are operable by the use of a screw driver and are provided in the side wall 22 of the housing to be flush with said side wall 22. Further, for redundancy reasons, each input definition is two-fold by the use of two independent rotary switches. Also for the output functions two rotary output switches 26 and 27 are used. With the use of the arrangement of these setting means in a side of the input module, the definition of input and output functions is not accessible after the module safety system has been arranged on the mounting rail due to of the protection of those rotary switches 24, 25, 26, and 27 by the adjacent side wall of the base module 1 as shown in Fig. 1. In an implemented embodiment, each rotary switch comprises 10 steps.

### REFERENCE NUMBERS

- 1: Base module
- 2: Input module
- 3: Output module
- 4: lower terminal row base module
- 5: lower terminal row base module
- 6: upper terminal row base module
- 7: upper terminal row base module
- 8: lower terminal row input module
- 9: upper terminal row input module
- 10: lower terminal row output module
- 11: upper terminal row output module
- 12: socket input module
- 13: first socket base module
- 14: second socket base module
- 15: socket output module
- 16: LED row
- 17: LED row
- 18: LED row
- 19: LED row
- 20: LED row
- 21: setting means
- 22: right side wall of input module housing
- 23: housing
- 24: rotary switch
- 25: rotary switch
- 26: rotary switch
- 27: rotary switch

## Claims

1. Modular safety system for safety control in emergency stop applications, comprising a base module (1) and at least one expansion module (2, 3), wherein each module is arranged in a housing with a rail mounting base so that the modules (1, 2, 3) are located side by side to each other after mounting to said rail, further comprising means (21) for setting required input and output functions of the modular safety system,
**characterized in that**
said setting means (21) is located on a module housing side, so that after mounting of said modules (1, 2, 3) to said rail, the setting means (21) is covered by the housing side of the adjacent module.

2. A system according to claim 1, **characterized in that** said setting means (21) is provided at said at least one expansion module (2, 3).

3. A system according to claim 2, **characterized in that** said expansion module (2, 3) is an input module (2) with one or more input channels.

4. A system according to any one of the preceding claims, **characterized in that** said setting means (21) comprises rotary switches (24, 25, 26, 27).

5. A system according to claim 4, **characterized in that** said system redundancy is achieved by providing two independent rotary switches (24, 25) for the input functions and two independent rotary switches (26, 27) for the output functions.

6. A system according to claim 5, **characterized in that** each rotary switch (24, 25, 26, 27) comprises a plurality of steps.

7. A system according to anyone of the preceding claims, **characterized in that** the system further comprises at least one output module (3).

8. A system according to any one of the preceding claims, **characterized in that** each input module (2) comprises two input channels.

9. A system according to claim 8, **characterized in that** each input channel comprises a single-, dual- or three-channel activation.

10. A system according to any one of the preceding claims, **characterized in that** the base module (1) is comprised in a 35mm housing.

11. A system according to any one of the preceding claims, **characterized in that** the input module (2) is comprised in a 17,5mm housing.

12. A system according to any one of the preceding claims, **characterized in that** the output module (3) is comprised in a 22,5mm housing.

## Patentansprüche

1. Modulares Sicherheitssystem für eine Sicherheitskontrolle bei Notstop-Anwendungen, umfassend ein Basismodul (1) und wenigstens ein Erweiterungsmodul (2, 3), wobei jedes Modul in einem Gehäuse mit einer Schienenmontagebasis angeordnet ist derart, dass die Module (1, 2, 3) nach der Montage auf dieser Schiene nebeneinander angeordnet sind, ferner umfassend Mittel (21) zum Einstellen geforderter Eingabe- und Ausgabefunktionen des modularen Sicherheitssystems, **dadurch gekennzeichnet, dass** die Einstellmittel (21) an einer Modulgehäuseseite angeordnet sind derart, dass nach dem Montieren dieser Module (1, 2, 3) auf der Schiene die Einstellmittel (21) durch die Gehäuseseite des benachbarten Moduls abgedeckt sind.

2. System nach Anspruch 1, **dadurch gekennzeichnet, dass** die Einstellmittel (21) an dem wenigstens ein Erweiterungsmodul (2, 3) vorgesehen sind.

3. System nach Anspruch 2, **dadurch gekennzeichnet, dass** das Erweiterungsmodul (2, 3) ein Eingabemodul (2) mit einem oder mehreren Eingabekanälen ist.

4. System nach einem der vorangehenden Ansprüche, **dadurch gekennzeichnet, dass** die Einstellmittel (21) Drehschalter (24, 25, 26, 27) umfassen.

5. System nach Anspruch 4, **dadurch gekennzeichnet, dass** die Systemredundanz **dadurch** erreicht wird, dass zwei unabhängige Drehschalter (24, 25) für die Eingabefunktionen und zwei unabhängige Drehschalter (26, 27) für die Ausgabefunktionen vorgesehen sind.

6. System nach Anspruch 5, **dadurch gekennzeichnet, dass** jeder Drehschalter (24, 25, 26, 27) mehrere Schaltstufen aufweist.

7. System nach einem der vorangehenden Ansprüche, **dadurch gekennzeichnet, dass** das System ferner wenigstens ein Ausgabemodul (3) umfasst.

8. System nach einem der vorangehenden Ansprüche, **dadurch gekennzeichnet, dass** jedes Eingabemodul (2) zwei Eingabekanäle aufweist.

9. System nach Anspruch 8, **dadurch gekennzeichnet, dass** jeder Eingabekanal eine Einkanal-, Zweikanal- oder Dreikanalaktivierung aufweist.

10. System nach einem der vorangehenden Ansprüche, **dadurch gekennzeichnet, dass** das Basismodul (1) in einem 35 mm-Gehäuse aufgenommen ist.

11. System nach einem der vorangehenden Ansprüche, **dadurch gekennzeichnet, dass** das Eingabemodul (2) in einem 17,5 mm-Gehäuse aufgenommen ist.

12. System nach einem der vorangehenden Ansprüche, **dadurch gekennzeichnet, dass** das Ausgabemodul (3) in einem 22,5 mm-Gehäuse aufgenommen ist.

## Revendications

1. Système de sécurité modulaire pour une commande de sécurité dans des applications d'arrêt d'urgence, comprenant un module (1) de base et au moins un module d'extension (2, 3), dans lesquels chaque module est agencé dans un logement muni d'une base de montage sur rail de sorte que les modules (1, 2, 3) soient placés côte à côte les uns des autres après montage sur ledit rail, comprenant en outre un moyen (21) destiné à régler des fonctions d'entrée et de sortie requises du système de sécurité modulaire,
**caractérisé en ce que**
ledit moyen de réglage (21) est placé sur un côté de logement de module, de sorte qu'après montage desdits modules (1, 2, 3) sur ledit rail, le moyen de réglage (21) soit couvert par le côté de logement du module adjacent.

2. Système selon la revendication 1, **caractérisé en ce que** ledit moyen de réglage (21) est prévu au niveau dudit au moins un module d'extension (2, 3).

3. Système selon la revendication 2, **caractérisé en ce que** ledit module d'extension (2, 3) est un module (2) d'entrée muni d'un ou de plusieurs canaux d'entrée.

4. Système selon l'une quelconque des revendications précédentes, **caractérisé en ce que** ledit moyen de réglage (21) comprend des commutateurs rotatifs (24, 25, 26, 27).

5. Système selon la revendication 4, **caractérisé en ce que** ladite redondance de système est obtenue grâce à la mise à disposition de deux commutateurs rotatifs (24, 25) indépendants pour les fonctions d'entrée et deux commutateurs rotatifs (26, 27) indépendants pour les fonctions de sortie.

6. Système selon la revendication 5, **caractérisé en ce que** chaque commutateur rotatif (24, 25, 26, 27) comprend une pluralité de pas.

7. Système selon l'une quelconque des revendications précédentes, **caractérisé en ce que** le système comprend en outre au moins un module (3) de sortie.

8. Système selon l'une quelconque des revendications précédentes, **caractérisé en ce que** chaque module (2) d'entrée comprend deux canaux d'entrée.

9. Système selon la revendication 8, **caractérisé en ce que** chaque canal d'entrée comprend une activation monocanal, bicanal ou tricanal.

10. Système selon l'une quelconque des revendications précédentes, **caractérisé en ce que** le module (1) de base se compose d'un logement de 35 mm.

11. Système selon l'une quelconque des revendications précédentes, **caractérisé en ce que** le module (2) d'entrée se compose d'un logement de 17,5 mm.

12. Système selon l'une quelconque des revendications précédentes, **caractérisé en ce que** le module (3) de sortie se compose d'un logement de 22,5 mm.
